# EUROPEAN PATENT APPLICATION

(11) **EP 1 850 475 A1**
(43) Date of publication of application: **31.10.2007**
(21) Application number: 06445017.4
(22) Date of filing: 25.04.2006
(51) Int. Cl.: H03F 3/45, H01Q 7/08, H01Q 23/00, H01Q 21/28

(54) **Antenna device and portable radio communication device comprising such antenna device**

(71) Applicant: AMC Centurion AB, 184 25 Akersberga (SE)
(72) Inventor: Kaikkonen, Andrei, 164 71 KISTA (SE); Lindberg, Peter, 752 29 Uppsala (SE)
(74) Representative: Estreen, Lars J.F.

(57) **Abstract**

An antenna device for a portable radio communication device adapted for receiving radio signals comprises a radiating element (10) comprising first and second feeding portions (11, 12) and an amplifier (20) connected to the first and second feeding portions of the radiating element and connectable to a feed device for radio signals (40). By providing the amplifier as a differential amplifier and by co-designing the impedance of the radiating element (10) and the amplifier (20) so as to together provide a predetermined resonance frequency of the antenna device, a small sized internal antenna device is provided while gain is maximized and amplifier noise is minimized.

## Description

### FIELD OF INVENTION

The present invention relates generally to antenna devices and more particularly to an antenna device for use in a radio communication device, such as a mobile phone, which is adapted for radio signals having a relatively low frequency, such as radio signals in the FM band.

### BACKGROUND

Internal antennas have been used for some time in portable radio communication devices. There are a number of advantages connected with using internal antennas, of which can be mentioned that they are small and light, making them suitable for applications wherein size and weight are of importance, such as in mobile phones.

However, the application of internal antennas in a mobile phone puts some constraints on the configuration of the antenna element. In particular, in a portable radio communication device the space for an internal antenna arrangement is limited. These constraints may make it difficult to find a configuration of the antenna that provides for a wide operating band. This is especially true for antennas intended for use with radio signals of relatively low frequencies as the desired physical length of such antennas are large compared to antennas operating with relatively high frequencies.

One specific application operating in a relatively low frequency band is the FM radio application. The FM band is defined as frequencies between 88-108 MHz in Europe or between 76-110 MHz in the USA. Prior art conventional antenna configurations, such as loop antennas or monopole antennas, fitted within the casing of a portable radio communication device will result in unsatisfactory operation in that the antenna either has too bad performance over a sufficiently wide frequency band or sufficient performance over a too narrow frequency band.

Instead, a conventional FM antenna for portable radio communication devices is provided in the headset wire connected to the communication device. This configuration with a relatively long wire permits an antenna length that is sufficient also for low frequency applications. However, if no external antenna is permitted this solution is obviously not feasible.

Another problem is that in case a second antenna, such as a GSM antenna, is provided in the same communication device as the FM antenna, this second antenna interferes with the operation of the FM antenna.

### SUMMARY OF THE INVENTION

An object of the present invention is to provide an internal antenna device for use in a portable radio communication device, which operates with sufficient performance throughout a frequency band having a relatively low frequency, such as the FM radio band.

The invention is based on the realization that a differential multiturn loop can be co-designed with a differential amplifier so as to provide an antenna device having advantageous characteristics.

According to the present invention there is provided an antenna device for a portable radio communication device adapted for receiving radio signals comprising a radiating element comprising first and second feeding portions, an amplifier connected to the first and second feeding portions of the radiating element and connectable to a feed device for radio signals, which is characterized in that the amplifier is a differential amplifier, and the impedance of the radiating element and the amplifier are chosen so as to together provide a predetermined resonance frequency of the antenna device. A portable radio communication device comprising such an antenna device is also provided.

By providing a differential amplifier co-designed with the radiating element so as to together provide a predetermined resonance frequency of the antenna device, a small sized antenna device operating in a relatively low frequency band is achieved, while gain is maximized and amplifier noise is minimized. By providing a differential amplifier, a balanced antenna device is provided which can be connected directly to the RF inputs of a receiver circuit, such as an FM receiver circuit.

In a preferred embodiment, the radiating element comprises a multiturn loop of electrically conductive wire, preferably with a magnetic material inside the loop. This provides a small sized antenna element.

Further preferred embodiments are defined in the dependent claims.

### BRIEF DESCRIPTION OF DRAWINGS

The invention is now described, by way of example, with reference to the accompanying drawings, in which:
FIG. 1 is an schematic diagram showing an antenna device according to the invention connected to an FM receiver circuit;
FIG. 2 is a diagram showing in more detail an antenna device according to the invention;
FIGS. 3 and 4 are diagrams similar to the one of FIG. 2 but with alternative embodiments of the antenna device according to the invention;
FIG. 5 is a diagram illustrating an antenna device operable in two spaced apart frequency bands; and
FIG. 6 is a perspective partially cut-away view of an antenna device according to the invention mounted in a portable radio communication device.

### DETAILED DESCRIPTION OF THE INVENTION

In the following, a detailed description of preferred embodiments of an antenna device and a portable radio communication device according to the invention will be given. In the several embodiments described herein, the same reference numerals are given to identical parts of the different embodiments.

In the following description and claims, the term radiating element is used. It is to be understood that this term is intended to cover electrically conductive elements arranged for receiving and/or transmitting radio signals. Also, by the term feeding device should be understood any device that can receive and/or transmit signals from/to a radiating element.

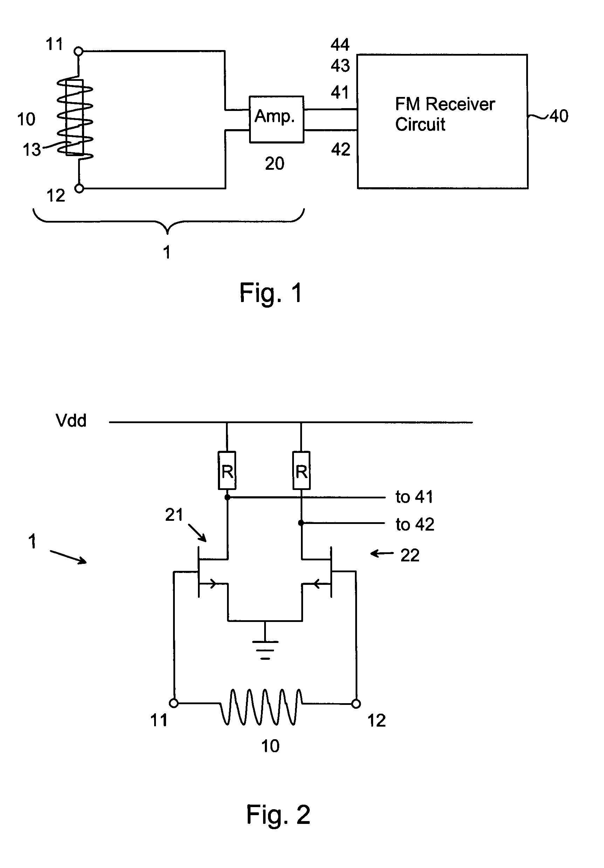

First with reference to FIG. 1, the general configuration of an antenna device according to the invention is shown, in this case a multi-turn loop antenna. The antenna, generally designated 1, comprises a radiating element in the form of a loop 10 of thin electrically conductive wire. First and second feeding portions 11 and 12 are connected to the loop and are adapted for connection to a balanced feeding device.

In order to increase inductance and radiation resistance of the antenna and attenuate high-frequency blocking signals a magnetic material, such as in the form of a ferrite rod 13, is provided inside the loop 10.

The antenna volume in a portable radio communication device is small, which results in a physically small antenna compared to the wavelength. This leads to a non-resonant loop antenna and an electrical impedance in the form of a differential amplifier 20 is connected to the feeding portions 11, 12 of the loop 10 to provide a resonant antenna in the desired frequency range. The impedance of the amplifier is co-designed with the impedance of the radiating element in order to achieve a desired resonance frequency of the antenna device.

An FM receiver circuit 40, which could be a conventional circuit manufactured by Philips Semiconductors and sold under the name HVQFN40, comprises two RF inputs 41, 42 which are connected to the amplifier 20. The FM receiver circuit 40 also comprises control outputs Vbias 43 and Vtune 44, which conventionally are used for controlling the gain and resonance frequency, respectively, of an external tuning circuit which is used to get the correct resonance frequency for the receiver 40. These outputs are used for controlling the antenna device as will be explained below.

An implementation of the general idea expressed in FIG. 1 will now be described with reference to FIG. 2, and particularly an implementation of the amplifier 20. The general configuration of the antenna device 1 is retained. Thus, it comprises a multiturn loop 10 of electrically conductive wire. The feeding portions 11 and 12 are connected to the gate connection of a respective field effect transistor (FET) 21, 22. The respective drain connection of the transistors is connected to a feed voltage Vdd via a load resistance R while the respective source connection of the transistors is connected to virtual ground, optionally connected to ground via a resistor in order to achieve common mode rejection.

The respective drain connection of the transistors 21, 22 is also connected to the feeding inputs of the FM receiver circuit 40.

With the above described circuitry, a simple embodiment of an antenna device according to the invention is achieved. The transistors 21, 22 function as a differential amplifier amplifying a radio signal, such as an FM radio signal received by the multiturn loop 10, and passing the amplified signal to the RF inputs of the FM receiver circuit 40.

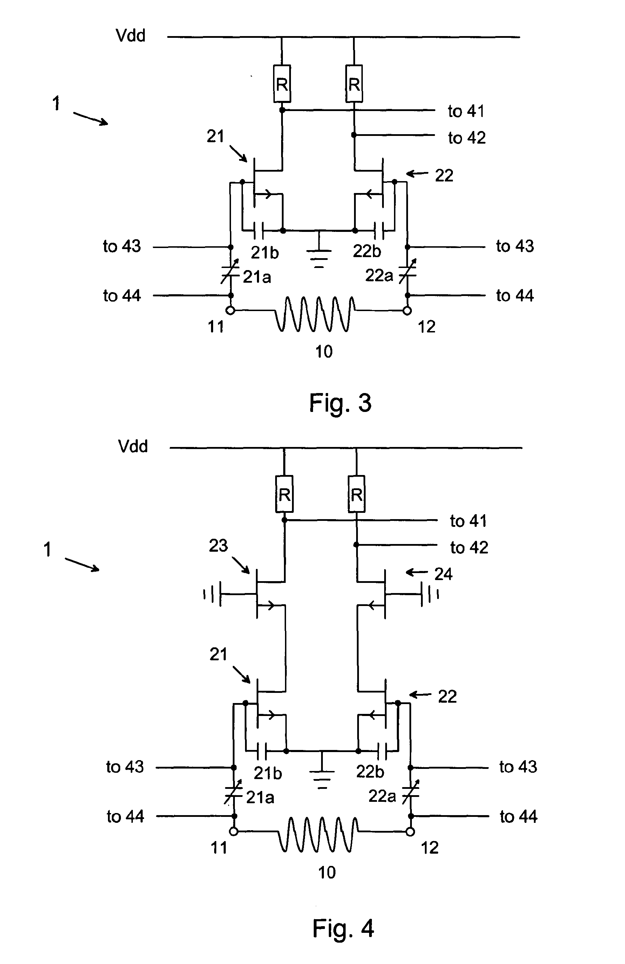

With a fixed impedance, such as in the configuration of FIG. 2, the antenna will operate in a fixed frequency range and with a fixed resonance frequency. Also, with a relatively small real part of the input impedance of the radiating element 10 compared to the imaginary part thereof, a relatively small bandwidth, such as about 1 MHz, is achieved. In order to be able to cover the entire desired bandwidth, in the case of the US/European FM band about 20 MHz, an alternative embodiment of an antenna device according to the invention is shown in FIG. 3, wherein a respective variable impedance 21a, 22a is provided between the feeding input 11, 12 and the gate of the transistors 21, 22. The variable impedance functions as a tuning circuit by means of which the resonant frequency band of the antenna device 1 can be adjusted. The circuitry can be implemented using the circuit ATF-55143 sold by Agilent Technologies.

In the preferred embodiment illustrated in FIG. 3, the variable capacitances 21a, 22a are varactor diodes, i.e., diodes wherein by varying the reverse voltage across the PN junction the junction capacitance can be varied. In this embodiment, the control outputs Vbias 43 and Vtune 44 of the FM receiver circuit 40 are connected across the varactor diodes 21a, 22a, and by varying the voltage across the varactor diodes by means of these output voltages, optionally remapped to suit the present application, the resonance frequency of the antenna device is adjusted.

In order to compensate for capacitive behavior, a shunt capacitor 21b, 22b having a fixed capacitance is connected between the gate and the source of the transistors 21, 22, i.e., between the gate and ground. As an example, these shunt capacitors could have an impedance value of 11 pF. This changes the input impedance of the amplifier 20 from for example Zin,amp=10-j2000 ohms to Zin,amp=10-j1000. This results in a wider frequency range. The shunt capacitors also improve noise matching by increasing the source resistance. Also, providing varistor diodes instead of capacitors 21b, 22b between the gate and the source of the transistors 21, 22 helps protecting the transistors from electrostatic discharges (ESD).

In yet an alternative embodiment of an antenna device according to the invention shown in FIG. 4, cascoded transistors 23, 24 are used to increase the input impedance of the amplifier 20, making it more stable by reducing the feedback capacitance (the Miller effect).

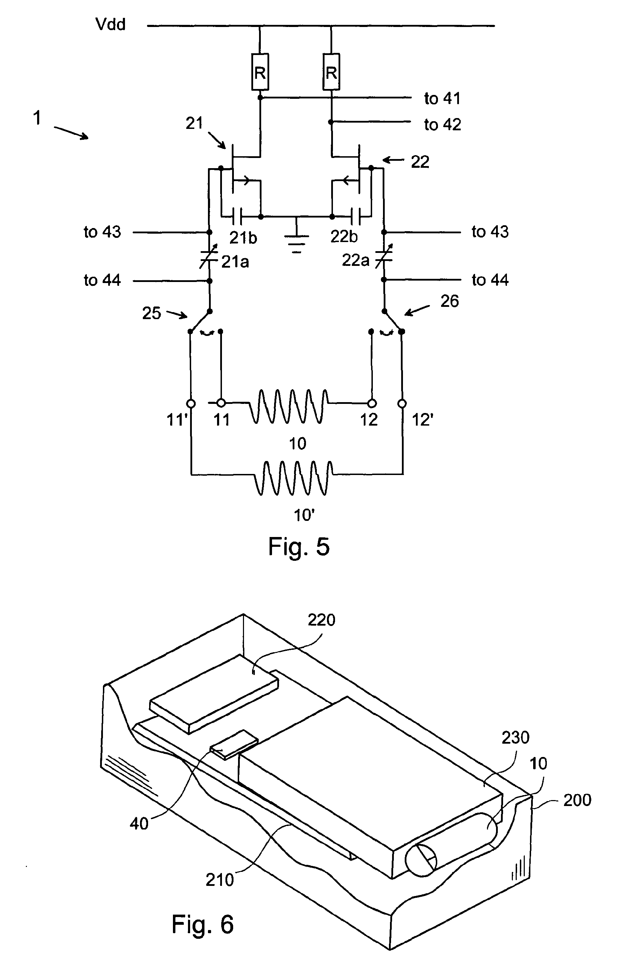

The above described embodiments of an antenna device according to the invention have been described as antenna devices adapted for reception of radio signals in the FM frequency band. However, other applications are also possible, such as use for digital video broadcasting (DVB) signals in the frequency range of about 400-800 MHz. In order to provide for operation in both the FM frequency range and the DVB frequency range, an alternative embodiment of the antenna device according to the invention as described with reference to FIG. 3 is provided with switches 25, 26 switching between a first multiturn loop 10 and a second multiturn loop 10', see FIG. 5. The first multiturn loop 10 has a higher inductance value such as 4 *µH* , while the second multiturn loop 10' has a lower inductance value such as 0.3 *µH ,* The first and second multiturn loops can be coaxial and wound around the same ferrite rod, saving space.

Thus, the embodiment shown in FIG. 5 provides electrically isolated radiating elements wound around the same ferrite rod allow tuning of the antenna device within two whole frequency bands, such as the DVB and FM frequency bands. In addition, such a configuration reutilizes ferrite rod and electronic circuits.

A preferred position of the antenna device according to the invention will now be described with reference to FIG. 6, wherein the general outlines of the casing of a portable radio communication device 200, such as a mobile phone, is depicted. The casing is shown partially cut away so as to not obscure the position of the antenna device, which could be any of the devices described with reference to FIGS 3-5.

A printed circuit board (PCB) 210 is provided in the casing, having the circuits (not shown) conventionally found in a mobile phone. On the PCB there is also mounted the FM receiver circuit 40. In the upper portion of the casing there is provided an antenna element 220 for receiving and transmitting RF signals for a mobile phone system, such as a GSM system.

A battery package 230 is also provided towards the back of the casing 200. This battery package is connected to the PCB by means of connectors (not shown).

The multiturn loop 10 is provided as far away as possible from the antenna element 220 and preferably with its longitudinal axis parallel to the short edge of the PCB in order to maximize the signal level.

Preferred embodiments of an antenna device according to the invention have been described. However, the person skilled in the art realizes that these can be varied within the scope of the appended claims without departing from the inventive idea.

It is realized that the shape and size of the antenna device according to the invention can be varied within the scope defined by the appended claims. Thus, the exact antenna configurations can be varied so as to correspond to the shape of the radio communication device, desired performance etc.

Although an antenna device for a portable radio communication device has been described with reference to its use in a mobile phone, it will be appreciated that the inventive idea is also applicable to other portable radio communication devices, also devices that are portable but primarily intended for stationary use. Examples thereof could be small clocks, such as travel alarm clocks, TV receivers, or game consoles. Yet a possible application of the antenna device according to the invention is in personal digital assistants (PDAs), MP3 and CD players, FM radio receivers, and laptop computers. A further application is in cars. Thus, the term portable radio communication device should be construed in a broad sense.

The multiturn loops have been described as being made of thin electrically conductive wire. It will be appreciated that other electrically conductive configurations, such as a coaxial cable with grounded shield, can be used as well.

A way of obtaining operation in two spaced apart frequency bands by switching between two radiating elements of different impedances has been described. It will be appreciated that another way to obtain dual frequency band operation is to provide one single radiating element and switch the resonance frequency by switching the varactors between parallel and series configuration, thereby adjusting the impedance of the amplifier.

## Claims

1. An antenna device for a portable radio communication device adapted for receiving radio signals, said antenna device comprising
- a radiating element (10) comprising first and second feeding portions (11, 12),
- an amplifier (20) connected to the first and second feeding portions of the radiating element and connectable to a feed device for radio signals (40),
**characterized in that**
- the amplifier is a differential amplifier, and
- the impedance of the radiating element (10) and the amplifier (20) are chosen so as to together provide a predetermined resonance frequency of the antenna device.

2. The antenna device according to claim 1, wherein the radiating element comprises a multiturn loop of electrically conductive wire.

3. The antenna device according to claim 1, comprising magnetic material (13) inside the multiturn loop (10).

4. The antenna device according to claim 2 or 3, comprising a further radiating element (10'), wherein the radiating element (10) and the further radiating element (10') are selectively connectable to the amplifier (20).

5. The antenna device according to claim 4, wherein the radiating element (10) and the further radiating element (10') are provided as two co-axial multiturn loops of electrically conductive wire.

6. The antenna device according to any of claims 1-5, wherein the differential amplifier (20) comprises transistors (21, 22), preferably field effect transistors.

7. The antenna device according to claim 6, comprising a variable impedance (21a, 22a) provided between the feeding input (11, 12) and the gate of the transistors (21, 22).

8. The antenna device according to claim 6 or 7, comprising shunt capacitors (21b, 22b) connected between the gate and the source of the transistors (21, 22).

9. The antenna device according to claim 1, wherein the impedance of the amplifier (20) is switchable between two different impedance values.

10. A portable radio communication device comprising an antenna device according to any of the preceding claims.
